# EUROPEAN PATENT APPLICATION

(11) **EP 2 608 248 A1**
(43) Date of publication of application: **26.06.2013**
(21) Application number: 11817884.7
(22) Date of filing: 15.07.2011
(51) Int. Cl.: H01L 21/26, C30B 29/06, C30B 33/02

(54) **HEAT TREATMENT METHOD FOR WAFER, METHOD FOR PRODUCING SILICON WAFER, SILICON WAFER, AND HEAT TREATMENT APPARATUS**

(30) Priority: 18.08.2010 JP 2010183020
(71) Applicant: Shin-Etsu Handotai Co., Ltd., Tokyo 100-0004 (JP)
(72) Inventor: EBARA, Koji, Annaka-shi Gunma 379-0196 (JP); OKA, Tetsuya, Annaka-shi Gunma 379-0196 (JP); TAKAHASHI, Shuji, Takasaki-shi Gunma 370-3533 (JP)
(74) Representative: Wibbelmann, Jobst
(86) International application number: PCT/JP2011/004047
(87) International publication number: WO 2012/023233

(57) **Abstract**

The present invention is a method for heat-treating a wafer, the method by which heat treatment at a predetermined temperature with rapid rise and fall of temperature is performed by performing heating by a heating source in a state in which a principal surface (a first principal surface) of a wafer is supported by a supporting member, the method in which heat treatment is performed with control of the heating source being performed in such a way that the temperature of the first principal surface supported by the supporting member becomes 1 to 25°C higher than the temperature of a principal surface (a second principal surface) opposite to the first principal surface of the wafer. As a result, a method for heat-treating a wafer, the method that can reliably suppress a slip dislocation generated from a wafer supporting position when heat treatment is performed on a silicon wafer, is provided.

## Description

### TECHNICAL FIELD

The present invention relates to methods for heat-treating a wafer such as a semiconductor wafer and, more particularly, the present invention relates to a method for heat-treating a wafer and a heat treatment apparatus that can reduce slip dislocations which are generated from a region of contact between a wafer and a wafer supporting member at the time of heat treatment, a method for producing a silicon wafer with few slip dislocations, the method having a heat treatment process, and a silicon wafer.

### BACKGROUND ART

A silicon wafer sliced out from a silicon single crystal ingot is subjected to many processes from a wafer processing process to an element forming process before device fabrication is performed.
One of these processes is a heat treatment process. Also in a silicon wafer processing process, heat treatment is sometimes performed in order to form a defect-free layer in a wafer surface layer, and form and control an oxide precipitate.

In the past, as this heat treatment, batch heat treatment has been adopted. In recent years, however, a method adopting lamp annealing or the like using an RTA (Rapid Thermal Anneal) apparatus that can perform treatment by rapidly raising and lowering the temperature in a shorter time has become more and more prevalent.
However, the drawback of normal RTA treatment is that a slip dislocation is generated because annealing is performed at a high temperature of 1100°C or higher. If this slip dislocation is generated, device characteristics are affected, and therefore a slip dislocation is required not to be generated in a few-µm region from the front surface on which a device is to be formed.

Here, a slip dislocation is considered to be generated mainly due to a stress produced by a self weight put on a region of contact between a support pin supporting a silicon wafer and the wafer, and a thermal stress produced due to nonuniform heat distribution caused by heat escaping through a pin during heat treatment.
In addition, this problem has become more pronounced as the self weight increases with an increase in the diameter of a wafer. Moreover, this problem tends to arise as the heat treatment temperature increases.

As a solution to this problem, in Patent Document 1, a method of performing, when performing RTA treatment, heat treatment while controlling a heat treatment temperature in such a way that the temperature of a wafer outer periphery becomes 1 to 6°C higher than the temperature of a central part is disclosed.

### CITATION LIST

### PATENT LITERATURE

Patent Document 1: Japanese Patent Application Laid-open No.2010-34288

### SUMMARY OF INVENTION

### PROBLEM TO BE SOLVED BY THE INVENTION

However, an intensive study made by the inventors of the present invention has revealed that, with the method described in Patent Document 1 described above, it is impossible to suppress a slip dislocation which is generated from a support pin position.
In particular, at a high temperature exceeding 1250°C, a slip dislocation is generated from a support pin position on a wafer back surface and penetrates to the front surface.

It is presumed that the cause of this is as follows.

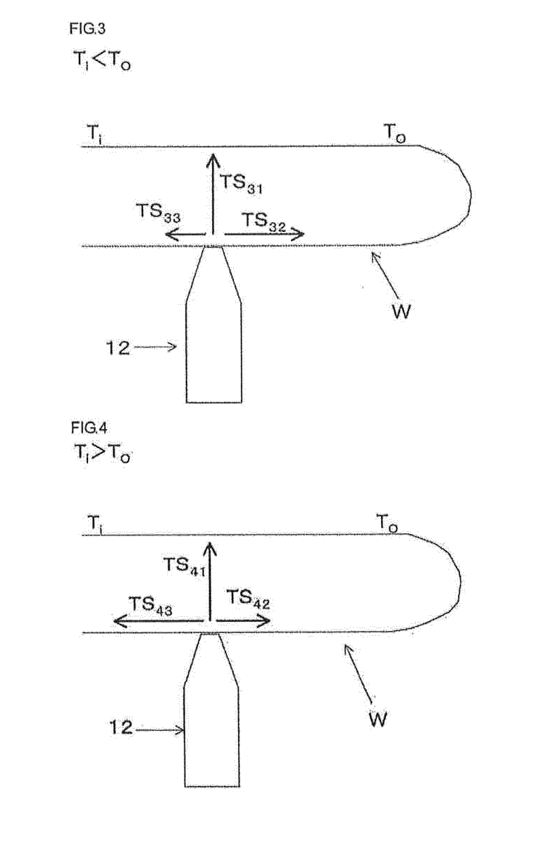

FIG. 3 is a conceptual diagram when the temperature of a wafer outer periphery is higher than the temperature of a central part, and FIG. 4 is a conceptual diagram when the temperature of the wafer central part is higher than the temperature of the outer periphery.

According to the description in Patent Document 1, the following explanation is given. When, as in FIG. 4, the temperature of a central part (Tᵢ) of a wafer W is higher than the temperature of an outer periphery (Tₒ) (Tᵢ > Tₒ), the amount of heat escaping from the wafer central part through a support pin 12 is large, a thermal stress TS₄₃ caused by a temperature difference becomes relatively large as compared to a thermal stress TS₄₁ applied to the side opposite to the support pin and a thermal stress TS₄₂ applied to the outer periphery, and a slip dislocation is generated.
On the other hand, the following explanation is given. As in FIG. 3, when the temperature of the outer periphery is made higher than that of the central part of the wafer W (Tᵢ < Tₒ), since the amount of heat escaping from the support pin 12 becomes smaller (which is construed as a reduction in the heat flow from the center of a wafer to the outer periphery), a thermal stress TS₃₃ caused by a temperature difference becomes smaller than TS₄₃ of FIG. 4, making it possible to prevent the generation of a slip dislocation.

However, an intensive study made by the inventors of the present invention has revealed that, in a case like FIG. 3, since the outer periphery temperature Tₒ of the wafer W becomes high, the heat flow from the outer periphery to the center becomes large, and, contrary to the above description, the amount of heat escaping from the outer periphery through the support pin becomes large. As a result, it is considered that a thermal stress TS₃₂ caused by a temperature difference becomes large.
It is presumed that these two effects cancel each other out and are ineffective in reducing slip dislocation.

Another problem is that, with the method described in Patent Document 1, making the temperature distribution on a wafer plane nonuniform not only makes the oxide film thickness distribution nonuniform, but increases a thermal stress caused by a temperature difference between the center and the outer periphery of a wafer, and a slip dislocation is easily generated from the wafer outer periphery.
In particular, it has been found out that, at a high temperature exceeding 1250°C, a slip dislocation is generated significantly from the wafer periphery.

The present invention has been made in view of the problems described above, and an object thereof is to provide a method for heat-treating a wafer, the method that can reliably suppress a slip dislocation which is generated from a wafer supporting position when heat-treating a silicon wafer, a heat treatment apparatus that can perform the method for heat-treating a wafer, a silicon wafer to which this method is applied, the silicon wafer in which the number of slip dislocations generated from the wafer supporting position is much smaller than that of an existing silicon wafer or a slip dislocation does not penetrate to at least the front surface, and a method for producing such a silicon wafer.

### MEANS FOR SOLVING PROBLEM

To solve the problems described above, the present invention provides a method for heat-treating a wafer, the method by which heat treatment at a predetermined temperature with rapid rise and fall of temperature is performed by performing heating by a heating source in a state in which a principal surface (a first principal surface) of a wafer is supported by a supporting member, wherein heat treatment is performed with control of the heating source being performed in such a way that the temperature of the first principal surface supported by the supporting member becomes 1 to 25°C higher than the temperature of a principal surface (a second principal surface) opposite to the first principal surface of the wafer.

As described above, by performing heat treatment while performing control in such a way that the temperature of the first principal surface of the wafer supported by the supporting member becomes 1 to 25°C higher than the temperature of the second principal surface opposite to the first principal surface, it is possible to reduce a thermal stress produced near the supporting member and suppress the generation of a slip dislocation more reliably than in the existing method. This makes it possible to obtain a heat-treated wafer with few slip dislocations.

Incidentally, the heat treatment at a predetermined temperature with rapid rise and fall of temperature in the present invention refers to heat treatment (RTA treatment) with rapid heating or cooling at the rate of temperature rise or fall of 5 to 250 °C/sec, preferably 20 to 150 °C/sec, more preferably 30 to 70°C/sec. Moreover, the predetermined temperature refers to a temperature range which is 700°C or higher but lower than a melting-point temperature of the wafer.

Here, it is preferable that control is performed in such a way that the temperature of the first principal surface becomes 1 to 25°C higher than the temperature of the second principal surface by changing the ratio of an output of a first heating source heating the first principal surface of the wafer to an output of a second heating source heating the second principal surface.
As described above, by changing the ratio of the output of the first heating source heating the first principal surface of the wafer to the output of the second heating source heating the second principal surface, it is possible to perform control in such a way that the temperature of the first principal surface becomes 1 to 25°C higher than the temperature of the second principal surface. This makes it possible to perform control with ease and reliability in such a way that the temperature of the first Principal surface becomes 1 to 25°C higher than the temperature of the second principal surface and suppress the generation of a slip dislocation more reliably.

Moreover, a halogen lamp can be used as the first heating source and the second heating source, and the output of the second heating source can be set to 10 to 90% of the output of the first heating source.
As described above, by using a halogen lamp as the first heating source and the second heating source and setting the output of the second heating source to 10 to 90% of the output of the first heating source, it is possible to perform control in such a way that the temperature of the first principal surface becomes 1 to 25°C higher than the temperature of the second principal surface more easily and reliably and suppress the generation of a slip dislocation more effectively.

In addition, a halogen lamp can be used as the heating source.
As described above, by using a halogen lamp as the heating source, it is possible to perform rapid heating with ease and perform heat treatment more easily.

Furthermore, it is preferable that the supporting member is made to support the outer periphery of the wafer horizontally at a plurality of supporting points.
Although a method by which the whole of an edge portion of the wafer is supported by a thin ring-shaped susceptor as the supporting member of the wafer is also possible, the method of the present invention for heat-treating a wafer is particularly effective when the wafer outer periphery is supported at a plurality of supporting points.

Moreover, the predetermined temperature can be set at 700°C or higher but lower than 1150°C.
A slip dislocation from a place where the supporting member is located is generated significantly when the heat treatment temperature is 700°C or higher, and the method of the present invention for heat-treating a wafer is particularly effective in suppressing such a slip dislocation which is generated significantly at a treatment temperature of 700°C or higher.

In addition, the predetermined temperature can be set at 1150°C or higher but lower than 1250°C.
In recent years, a method by which control of an oxide precipitate is performed by performing RTA treatment on a silicon wafer when a silicon wafer is used as a wafer has been disclosed (refer to, for example, Japanese translation of PCT international application No.2001-503009) and is being widely adopted. In addition, in many cases, the treatment temperature of the RTA treatment is 1150°C or higher but lower than 1250°C. At such a high temperature, a slip dislocation is generated more significantly, and therefore the method of the present invention for heat-treating a wafer is more effective when RTA treatment at 1150°C or higher but lower than 1250°C is performed.

Furthermore, the predetermined temperature can be set at 1250°C or higher.
Moreover, in recent years, a method for melting grown-in defects (such as COPs) by performing RTA treatment at a high temperature higher than 1300°C has been disclosed (refer to, for example, Japanese Patent Application Laid-open No.2010-40589).
An intensive study made by the inventors of the present invention has revealed that, although a slip dislocation is generated from a position supported by the supporting member when the RTA temperature is lower than 1250°C, the slip dislocation rarely affects directly the device characteristics because the slip dislocation does not penetrate to the front surface. However, the generation of a slip dislocation leads to a problem of a reduction of wafer strength, and therefore the smaller the number of slip dislocations, the better. Thus, the method of the present invention for heat-treating a wafer is performed particularly suitably even when the temperature is lower than 1250°C as described above.
In addition, since, at 1250°C or higher, a slip dislocation generated from the supporting member position penetrates to the front surface, the slip dislocation greatly affects the device characteristics. However, with the method of the present invention for heat-treating a wafer, even when a slip dislocation is generated, the slip dislocation does not penetrate to the front surface and many of the slip dislocations can be stopped in a bulk, making it possible to prevent a dislocation from being generated in a few-µm range from the front surface which is a device fabrication region.
As described above, the method of the present invention for heat-treating a wafer is particularly effective when heat treatment at a temperature of 1250°C or higher is performed.

Moreover, the present invention provides a method for producing a silicon wafer, including at least: growing a silicon single crystal ingot by the Czochralski method; slicing and processing the silicon single crystal ingot into a silicon single crystal substrate; and performing heat treatment on the silicon single crystal substrate by the method for heat-treating a wafer, the method described in the present invention.
As described above, since the method of the present invention for heat-treating a wafer can suppress the generation of a slip dislocation reliably, with the method for producing a silicon wafer, the method using the above method, it is possible to produce a silicon wafer of good quality, the silicon wafer in which the number of slip dislocations is greatly reduced as compared to that of an existing silicon wafer, more efficiently than an existing method.

In addition, the present invention provides a silicon wafer, which is a silicon wafer on which heat treatment has been performed by the method for heat-treating a wafer, the method described in the present invention.
As described above, a silicon wafer on which the method of the present invention for heat-treating a wafer has been performed is a silicon wafer of good quality in which the number of slip dislocations is greatly reduced as compared to that of an existing silicon wafer.

Furthermore, the present invention provides a heat treatment apparatus for performing, on a wafer, heat treatment at a predetermined temperature with rapid rise and fall of temperature, including at least: a chamber for housing the wafer; a supporting member supporting a first principal surface of the wafer; a first heating source heating the first principal surface of the wafer; a second heating source heating a principal surface (a second principal surface) opposite to the first principal surface of the wafer; and a control mechanism for controlling outputs of the first heating source and the second heating source separately, wherein the control mechanism controls the outputs of the first heating source and the second heating source separately in such a way that the temperature of the first principal surface supported by the supporting member becomes 1 to 25°C higher than the temperature of the principal surface (the second principal surface) opposite to the first principal surface of the wafer.

This provides an apparatus that can reduce a thermal stress near the supporting member in the wafer during heat treatment as compared to that in an existing example, reduce greatly the probability of generation of a slip dislocation which would be generated in the wafer subjected to heat treatment, and obtain a wafer with few slip dislocations.

Here, it is preferable that the first and second heating sources are halogen lamps.
As described above, by using a halogen lamp as the heating source, it is possible to perform rapid heating with ease and perform more easily heat treatment during which control is performed in such a way that the temperature of the first principal surface becomes higher than the temperature of the second principal surface.

### EFFECT OF THE INVENTION

As described above, according to the present invention, a method for heat-treating a wafer, the method that can reliably suppress a slip dislocation which is generated from a wafer supporting position when heat-treating a silicon wafer, a heat treatment apparatus that can perform the method for heat-treating a wafer, a silicon wafer to which this method is applied, the silicon wafer in which the number of slip dislocations generated from the wafer supporting position is much smaller than that of an existing silicon wafer or a slip dislocation does not penetrate to at least the front surface, and a method for producing such a silicon wafer are provided.

### BRIEF DESCRIPTION OF DRAWINGS

FIG. 1 is a conceptual diagram when heat treatment is performed with control of heating sources being performed in such a way that the temperature of a first principal surface making contact with a supporting member supporting a wafer of the present invention becomes 1 to 25°C higher than the temperature of a second principal surface;
FIG. 2 is a diagram showing an example of an outline of a heat treatment apparatus of the present invention;
FIG. 3 is a conceptual diagram when the temperature of a wafer outer periphery is higher than the temperature of a central part in an existing heat treatment method;
FIG. 4 is a conceptual diagram when the temperature of the wafer central part is higher than the temperature of the outer periphery in the existing heat treatment method; and
FIG. 5 is a conceptual diagram when heat treatment is performed by making the temperature of a first principal surface making contact with a supporting member supporting an existing wafer equal to the temperature of a second principal surface.

### DESCRIPTION OF EMBODIMENTS

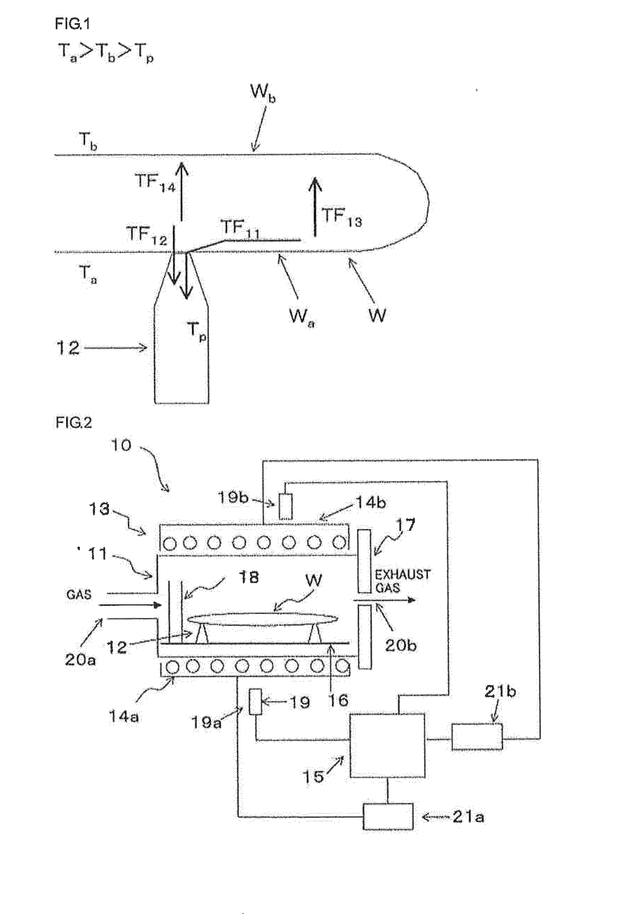

Hereinafter, the present invention will be described in detail with reference to the drawings. However, the present invention is not limited to the following description. FIG. 2 is a diagram showing an example of an outline of a heat treatment apparatus of the present invention.

As shown in FIG. 2, a heat treatment apparatus 10 of the present invention, the heat treatment apparatus 10 for performing heat treatment (RTA treatment) at a predetermined temperature with rapid rise and fall of temperature on a wafer W, includes at least a chamber 11 made of quartz, the chamber 11 for housing the wafer W, a supporting member (for example, a three-point support pin) 12 that is formed on a quartz tray 16, for example, and supports a first Principal surface of the wafer W, a first heating source (for example, a halogen lamp) 14a heating the first principal surface of the wafer W and a second heating source (for example, a halogen lamp) 14b heating a principal surface (a second principal surface) opposite to the first principal surface of the wafer W, and a control mechanism 15 for controlling the outputs of the first heating source 14a and the second heaving source 14b separately.

Moreover, in the chamber 11, an unillustrated special window for measuring temperatures is provided, and it is possible to measure the temperature of the wafer W through the special window by a pyrometer 19 provided outside the chamber 11 and transmit a signal of the measured temperature to the control mechanism 15. In this case, the pyrometer 19 may include a first pyrometer 19a measuring the temperature of the first principal surface of the wafer W and a second pyrometer 19b measuring the temperature of the second principal surface and transmit the measured temperatures obtained thereby to the control mechanism 15.

In addition, the control mechanism 15 can control the outputs of the first heating source 14a and the second heating source 14b separately in such a way that the temperature of the first principal surface supported by the supporting member 12 becomes 1 to 25°C higher than the temperature of the second principal surface by controlling electric power supply devices 21a (for controlling the first heating source 14a) and 21b (for controlling the second heating source 14b) in accordance with a difference between the set temperature and the measured wafer temperature and a power ratio set by a recipe in advance.

Moreover, as for atmospheric gas at the time of heat treatment, a quartz buffer 18 is provided on the side of the quartz tray 16 where a gas feed port 20a is provided, making it possible to prevent fed gas such as oxidizing gas, nitriding gas, or Ar gas from blowing directly on the wafer W. In addition, on the gas exhaust side, an automatic shutter 17 is provided and keeps outside air out. The automatic shutter 17 is provided with an unillustrated wafer insertion opening configured to be openable and closable by a gate valve. Moreover, the automatic shutter 17 is provided with a gas exhaust port 20b, which makes it possible to adjust the furnace atmosphere.

In the heat treatment apparatus 10 structured as described above, the outputs of the first heating source 14a heating the first principal surface of a wafer and the second heating source 14b heating the principal surface (the second principal surface) opposite to the first principal surface of the wafer are controlled separately by the control mechanism 15 that controls the outputs in such a way that the temperature of the first principal surface becomes 1 to 25°C higher than the temperature of the second principal surface, making it possible to generate, as a heat flow in the wafer, not only a heat flow flowing in the direction in which the supporting member is located but also a heat flow flowing to the wafer front surface during heat treatment of the wafer. In addition, the presence of this heat flow reduces the temperature gradient near the supporting member, making it possible to reduce a thermal stress near the supporting member as compared to that in an existing example. Therefore, the generation of a slip dislocation in the wafer after heat treatment, the slip dislocation which is generated significantly near the supporting member, is greatly suppressed as compared to the existing example, making it possible to provide a heat treatment apparatus that can obtain a high-quality heat-treated wafer with few slip dislocations.

In addition to the above-described method, as a method for performing temperature control in such a way that the temperature of the first principal surface becomes 1 to 25°C higher than the temperature of the second principal surface, the following method, for example, is also possible.
Only the pyrometer 19a measuring the temperature of the first principal surface is provided, RTA treatment is performed in advance in an oxygen atmosphere by using this pyrometer 19a, the relationship among the outputs of the heating sources, the temperature, and the oxide film thickness is obtained, and the outputs of the first heating source 14a and the second heating source 14b can be determined by using this relationship in such a way that a temperature difference between the first principal surface and the second principal surface becomes a predetermined temperature difference.
Furthermore, it is also possible to make the output of one lamp of each of the first heating source 14a and the second heating source 14b constant and change the ratio of the number of lamps of the first heating source 14a to the number of lamps of the second heating source 14b.
Alternatively, by using different types of lamp (lamps with different light-emitting characteristics) for the first heating source 14a and the second heating source 14b, since these lamps are constant in power supply but different in light-emitting characteristics, it is possible to change the ratio of the output of the first heating source 14a to the output of the second heating source 14b.

An example of a method for heat-treating a wafer, the method of the present invention using the above-described heat treatment apparatus of the present invention, will be described below. However, the present invention is not limited to this example.

The characteristic of the heat treatment method of the present invention is that, when heat treatment at a predetermined temperature with rapid rise and fall of temperature is performed by heating a wafer typified by a silicon wafer by heating sources in a state in which the wafer is supported by a supporting member, the heat treatment is performed with control of the heating sources being performed in such a way that the temperature of a first principal surface supported by the supporting member becomes 1 to 25°C higher than the temperature of a principal surface (a second principal surface) opposite to the first principal surface of the wafer.
The mechanism by which a slip dislocation which is generated from a wafer supporting position in the supporting member is suppressed reliably is unclear, but it is presumed that the mechanism is as follows.

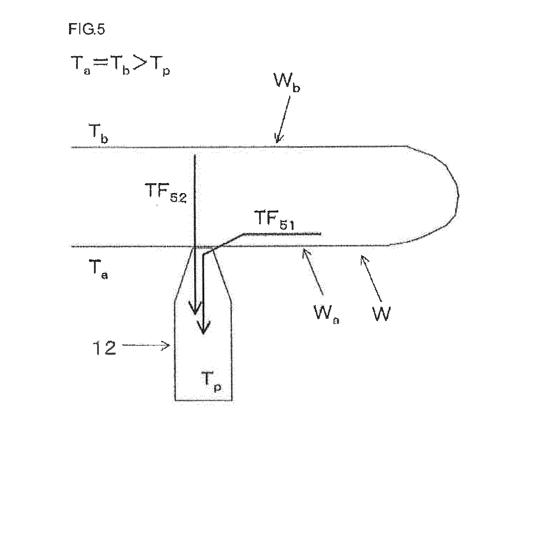

FIG. 1 is a conceptual diagram when, as in the present invention, heat treatment is performed with control of the heating sources being performed in such a way that the temperature of the first principal surface making contact with the supporting member supporting the wafer becomes 1 to 25°C higher than the temperature of the second principal surface. Moreover, FIG. 5 is a conceptual diagram when, as in the existing example, heat treatment is performed by making the temperature of the first principal surface making contact with the supporting member supporting the wafer equal to the temperature of the second principal surface.

As in FIG. 5, when the temperature of a first principal surface Wₐ making contact with the supporting member 12 supporting the wafer is made equal to the temperature of a second principal surface W_{b}, letting the temperature of the second principal surface W_{b} of a silicon wafer W be T_{b}, the temperature of the first principal surface, which slightly away from a position of contact in which the supporting member 12 and the silicon wafer W make contact with each other on the first principal surface Wₐ, of the silicon wafer be Tₐ, and the temperature of the silicon wafer in the position of the supporting member be Tₚ, Tₐ = T_{b} > Tₚ holds.
Therefore, the heat flows generated by a temperature difference mainly include the following two types:
(1) a heat flow TF₅₁ flowing from the first principal surface Wₐ to the supporting member 12; and
(2) a heat flow TF₅₂ flowing from the second principal surface W_{b} to the supporting member 12. It is considered that this increases the temperature gradient near the supporting member 12, which produces a great thermal stress and results in the generation of a slip dislocation.

On the other hand, in FIG. 1 according to the present invention, letting the temperature of the second principal surface W_{b} of the silicon wafer W be T_{b}, the temperature of the first principal surface Wₐ, which slightly away from a position of contact in which the supporting member 12 and the silicon wafer W make contact with each other on the first principal surface Wₐ, of the silicon wafer be Tₐ, and the temperature of the silicon wafer W in a position of contact between the first principal surface Wₐ and the supporting member 12 be Tₚ, Tₐ > T_{b} > Tₚ holds.

Therefore, the heat flows generated by a temperature difference include four types:
(1) a heat flow TF₁₁ flowing from the first principal surface Wₐ to the supporting member 12;
(2) a heat flow TF₁₃ flowing from the first principal surface Wₐ to the second principal surface W_{b};
(3) a heat flow TF₁₂ flowing from a bulk portion of the wafer W to the supporting member 12; and
(4) a heat flow TF₁₄ flowing from the bulk portion of the wafer W to the second principal surface W_{b}, and there are not only the heat flows flowing to the supporting member 12 but also the heat flows TF₁₃ and TF₁₄ flowing to the second principal surface W_{b}.
As a result, it is considered that the temperature gradient near the supporting member 12 is reduced as compared to that in the existing example and the thermal stress is reduced, making it possible to suppress the generation of a slip dislocation reliably.

Incidentally, when a temperature difference between the temperature of the first principal surface Wₐ of the wafer W and the second principal surface W_{b} is lower than 1°C, a mechanism for suppressing the generation of a slip dislocation hardly works because the heat flow TF₁₃ flowing from the first principal surface Wₐ to the second principal surface W_{b} and the heat flow TF₁₄ flowing from the wafer bulk portion to the second principal surface W_{b} become small, making it almost impossible to suppress the generation of a slip dislocation.
Moreover, when a temperature difference between the temperature of the first principal surface Wₐ of the wafer W and the second principal surface W_{b} is higher than 25°C, since a temperature difference between the first principal surface Wₐ and the second principal surface W_{b} becomes too large, the heat flows TF₁₃ and TF₁₄ in the wafer become large and a thermal stress produced in the wafer is increased, making it difficult to suppress the generation of a slip dislocation.
Therefore, it is necessary to perform heat treatment while performing control in such a way that the temperature of the first principal surface of the wafer supported by the supporting member becomes 1 to 25°C higher than the temperature of the second principal surface opposite to the first principal surface.

As described above, by performing heat treatment while performing control in such a way that the temperature of the first principal surface of the wafer supported by the supporting member becomes 1 to 25°C higher than the temperature of the second principal surface opposite to the first principal surface, there are not only a heat flow flowing in the direction in which the supporting member is located but also a heat flow flowing to the front surface during heat treatment as described above, and the temperature gradient near the supporting member is reduced. This reduces a thermal stress which is produced near the supporting member, making it possible to suppress the generation of a slip dislocation greatly as compared to the existing example and obtain a wafer with few slip dislocations.

Here, by changing the ratio of the output of the first heating source 14a heating the first principal surface Wₐ of the wafer W to the output of the second heating source 14b heating the second principal surface W_{b}, it is possible to perform control in such a way that the temperature of the first principal surface. Wₐ becomes 1 to 25°C higher than the temperature of the second principal surface W_{b}.
As described above, by changing the ratio of the output of the first heating source heating the first principal surface of the wafer to the output of the second heating source heating the second principal surface, it is possible to perform control in such a way that the temperature of the first principal surface becomes 1 to 25°C higher than the temperature of the second principal surface with stability and reliability and suppress the generation of a slip dislocation more stably and reliably.

Moreover, it is possible to use a halogen lamp as the heating source 13, in particular, as the first heating source 14a and the second heating source 14b. In addition, the output of the second heating source 14b can be set to 10 to 90% of the output of the first heating source 14a.
As described above, by using a halogen lamp as the heating source, in particular, as the first heating source and the second heating source, it is possible to perform rapid heating with ease, making it easier to perform heat treatment.
In addition, since control can be performed in such a way that the temperature of the first principal surface becomes 1 to 25°C higher than the temperature of the second principal surface more stably and reliably by setting the output of the second heating source to 10 to 90% of the output of the first heating source, it is possible to suppress the generation of a slip dislocation more reliably.

Furthermore, it is possible to make the supporting member 12 support the outer periphery of the wafer W horizontally at a plurality of supporting points.
As described above, since the method of the present invention for heat-treating a wafer can suppress the generation of a slip dislocation even when the wafer outer periphery is supported at a plurality of supporting points, a susceptor that supports the outer periphery of the wafer W horizontally at a plurality of supporting points can be suitably used.

Moreover, it is possible to set the predetermined temperature at which the wafer is heated at 700°C or higher but lower than 1150°C, 1250°C or higher but lower than 1250°C, or 1250°C or higher (preferably, lower than a melting-point temperature of the wafer).

In general, when heat treatment is performed on a silicon wafer, if the heating temperature becomes 700°C or higher, a slip dislocation tends to be generated from the location of the supporting member supporting the wafer. However, the method of the present invention for heat-treating a wafer, the method that can suppress the generation of a slip dislocation reliably, is suitable because the method can reliably suppress the generation of a slip dislocation that is generated at such a treatment temperature of 700°C or higher.

Moreover, when control of an oxide precipitate is performed by performing RTA treatment on a silicon wafer, the control is often performed at a treatment temperature of 1150°C or higher but lower than 1250°C. However, at such a high temperature, a slip dislocation is generated significantly.
In such a case, the method of the present invention for heat-treating a wafer can be used particularly effectively.

In addition, it is known that grown-in defects (such as COPs) are melted by RTA treatment performed at a high temperature higher than 1300°C, and the method of the present invention for heat-treating a wafer, the method that can suppress the generation of a slip dislocation reliably, is particularly effective also in performing heat treatment at a temperature of 1250°C or higher at which a slip dislocation generated from a supporting member position tends to penetrate to the front surface.

Then, after a silicon single crystal ingot is grown by the Czochralski method and the silicon single crystal ingot is sliced and processed into a silicon single crystal substrate, by performing heat treatment on the silicon single crystal substrate by the method for heat-treating a wafer, the method described in the present invention, it is possible to produce a high-quality silicon wafer with slip dislocations whose number is greatly reduced as compared to that of an existing silicon wafer more efficiently than an existing method.

Incidentally, at this time, a silicon single crystal substrate to be produced simply has to be a common silicon single crystal substrate, and a conductivity type, electric characteristic values such as resistivity, crystal orientation, a crystal diameter, etc. are not limited. However, the present invention is particularly effective in heat treatment of large-diameter wafers having a diameter of 8 inches (200 mm) and 12 inches (300 mm) and a larger-diameter wafer which are wafers having greater self-weights, the wafers in which a slip dislocation is generated more easily.
Moreover, a common method of processing of a silicon single crystal ingot into a silicon single crystal substrate may be adopted, and, for example, the silicon single crystal ingot can be sliced by a cutting apparatus such as an inner diameter slicer or a wire saw. Moreover, lapping, etching, polishing, etc. can be performed under common conditions and can be selected appropriately in accordance with the specifications of a silicon wafer to be produced.

### EXAMPLES

Hereinafter, the present invention will be described more specifically based on Examples and Comparative Examples; however, the present invention is not limited thereto.

### (Examples 1 to 5, Comparative Examples 1 to 3)

As a heat treatment apparatus that rapidly raises and lowers a temperature, Helios manufactured by Mattson Technology, Inc. was used. Moreover, to this apparatus, a control mechanism that can change the lamp outputs of an upper lamp module (a halogen lamp) corresponding to the second heating source and a lower lamp module (a halogen lamp) corresponding to the first heating source at an arbitrary ratio was added.
Then, a p-type silicon wafer having a diameter of 300 mm was prepared, carried into a chamber through an opening of the heat treatment apparatus, and placed on three quartz support pins and held horizontally. At this time, a side supported by the support pins was a first principal surface and an opposite side was a second principal surface.

Thereafter, oxygen gas was fed into the chamber, the temperature thereof was raised to a predetermined heat treatment temperature at the rate of 50°C/sec, and heat treatment was performed for ten seconds at each of the predetermined temperatures (1200°C, 1250°C, 1300°C, and 1350°C).
Then, when the temperature was lowered to 800°C at the rate of temperature fall of 50°C/sec, heating was turned OFF, and the wafer was then cooled to 500°C in the chamber and taken out of the chamber.

The ratio of the output of the upper lamp module to the output of the lower lamp module at the time of this heat treatment was set so that, in Comparative Example 1, the upper output : the lower output = 100:100 (a temperature difference (the first principal surface - the second principal surface): 0°C). Moreover, the ratio was set so that the upper output : the lower output = 100:60 (a temperature difference: -5°C) in Comparative Example 2, the upper output : the lower output = 90:100 (a temperature difference: 1°C) in Example 1, the upper output : the lower output = 80:100 (a temperature difference: 8°C) in Example 2, the upper output : the lower output = 40:100 (a temperature difference: 15°C) in Example 3, the upper output : the lower output = 20:100 (a temperature difference: 18°C) in Example 4, the upper output : the lower output = 10:100 (a temperature difference: 23°C) in Example 5, and the upper output : the lower output = 5:100 (a temperature difference: 33°C) in Comparative Example 3.

Then, the oxide film thicknesses of the first principal surface and the second principal surface were measured by an ellipsometer, and a temperature difference between the first principal surface and the second principal surface was calculated based on the film thicknesses.
Furthermore, a slip dislocation on the wafer front surface (the second principal surface) was measured by a laser scatting foreign matter inspection apparatus (SP1 manufactured by KLA-Tencor Corporation).
The results are shown in Table 1. Incidentally, a Good in Table 1 means that no slip dislocation was generated in three support pin positions, a Fair means that a slip dislocation was generated in one or two positions, and a Poor means that a slip dislocation was generated in all of the three positions.

**[Table 1]**

| | Power Ratio of Halogen Lamp (First Principal Surface:Second Principal Surface) | Temperature Difference (°C) | 1200°C | 1250°C | 1300°C | 1350°C |
|---|---|---|---|---|---|---|
| | | (First principal Surface-Second Principal Surface) | | | | |
| Comparative Example 1 | 100:100 | 0 | Good | Poor | Poor | Poor |
| Comparative Example 2 | 60:100 | -5 | Good | Poor | Poor | Poor |
| Example 1 | 100:90 | 1 | Good | Good | Good | Fair |
| Example 2 | 100:80 | 8 | Good | Good | Good | Good |
| Example 3 | 100:40 | 15 | Good | Good | Good | Good |
| Example 4 | 100:20 | 18 | Good | Good | Good | Good |
| Example 5 | 100:10 | 23 | Good | Good | Good | Fair |
| Comparative Example 3 | 100:5 | 33 | Good | Good | Fair | Poor |

As is clear from Table 1, in Examples 1 to 5 in which the temperature of the first principal surface is 1 to 23°C higher than the temperature of the second principal surface, the generation of a slip dislocation is suppressed greatly, and it is confirmed that the present invention is effective.
Incidentally, in the case of 1200°C, in all of Comparative Examples 1 to 3 and Examples 1 to 5, no slip dislocation was generated. This is because a slip dislocation detected by the SP1 is only the front surface. Also in this case, when evaluation is performed with X-rays or selective etching, a slip dislocation is generated from a portion in which the support pin and the wafer make contact with each other and extends in the direction of the front surface of the bulk, but this slip dislocation is not detected by the SP1 because it does not penetrate to the front surface. As a result of observations of the inside with X-rays, in any of these cases, the wafers on which heat treatment was performed by the methods of Examples 1 to 5 have shorter slip dislocations as compared to those of Comparative Examples 1 to 3, and it is confirmed that the present invention is effective in presenting or reducing slip dislocations.

### (Example 6, Comparative Example 4)

As a heat treatment apparatus that rapidly raises and lowers a temperature, Helios manufactured by Mattson Technology, Inc. was used. Moreover, to this apparatus, a control mechanism that can change the lamp outputs of an upper lamp module (a halogen lamp) corresponding to the second heating source and a lower lamp module (a halogen lamp) corresponding to the first heating source at an arbitrary ratio was added.
Then, a p-type silicon wafer having a diameter of 300 was prepared, carried into a chamber through an opening of the RTA apparatus, and placed on three quartz support pins and held horizontally. At this time, a side supported by the support pins was a first principal surface and an opposite side was a second principal surface.

Thereafter, oxygen gas was fed into the chamber, the temperature thereof was raised to a predetermined heat treatment temperature at the rate of 50°C/sec, and heat treatment was performed for ten seconds at each of the predetermined temperatures (700°C, 1100°C, and 1300°C).
Then, when the temperature was lowered to 800°C at the rate of temperature fall of 50°C/sec, heating was turned OFF, and the wafer was then cooled to 500°C in the chamber and taken out of the chamber.

The ratio of the output of the upper lamp module to the output of the lower lamp module and a temperature difference between the wafer outer periphery and inner periphery at this time were set in Comparative Example 4 so that the upper output : the lower output = 100:100 (a temperature difference (the first principal surface - the second principal surface): 0°C) and the temperature of the wafer outer periphery was 5°C higher than the temperature of the central part. In addition, in Example 6, the upper output : the lower output = 40:100 (a temperature difference: 15°C) and the temperature of the wafer outer periphery was equal to the temperature of the central part.

After heat treatment, a slip dislocation on the wafer front surface was measured by a laser scatting foreign matter inspection apparatus (SP1 manufactured by KLA-Tencor Corporation), and the length of the slip dislocation generated from a support pin contact position was evaluated by selective etching. The results are shown in Table 2. A Good in the table means that no slip dislocation was generated in three support pin positions, a Fair means that a slip dislocation was generated in one or two positions, and a Poor means that a slip dislocation was generated in all of the three positions.

**[Table 2]**

| | | 700°C | 1100°C | 1300°C | Power Ratio of Halogen Lamp (First Principal Surface:Second Principal Surface) |
|---|---|---|---|---|---|
| Comparative Example 4 | Surface Slip | Good | Good | Poor | 100:100 |
| | Slip Dislocation Length (mm) | 0.5 | 2 | 8 | |
| Example 6 | Surface Slip | Good | Good | Good | 100:40 |
| | Slip Dislocation Length (mm) | 0.2 | 1.2 | 3 | |

As is clear from Table 2, in Comparative Example 4 (the method described in Patent Document 1), the slip dislocation generated from the support pin position when heat treatment was performed at 1300°C penetrated to the front surface (the second principal surface). On the other hand, in Example 6, since the slip dislocation did not penetrate to the front surface, the slip dislocation was not detected by the SP1.
Moreover, in the case of Comparative Example 4, when RTA treatment was performed at 1300°C, it was confirmed that a slip dislocation was also generated from a wafer edge portion. In other wafers, there was no slip dislocation generated from an edge portion.
Furthermore, in Example 6, the length of the slip dislocation generated from the support pin position became shorter than that in Comparative Example 4 at any temperature, and it is confirmed that the method of the present invention is effective in preventing or reducing slip dislocations.

It is to be understood that the present invention is not limited in any way by the embodiment thereof described above. The above embodiment is merely an example, and anything that has substantially the same structure as the technical idea recited in the claims of the present invention and that offers similar functions and effects falls within the technical scope of the present invention.

## Claims

1. A method for heat-treating a wafer, the method by which heat treatment at a predetermined temperature with rapid rise and fall of temperature is performed by performing heating by a heating source in a state in which a principal surface (a first principal surface) of a wafer is supported by a supporting member, wherein
heat treatment is performed with control of the heating source being performed in such a way that the temperature of the first principal surface supported by the supporting member becomes 1 to 25°C higher than the temperature of a principal surface (a second principal surface) opposite to the first principal surface of the wafer.

2. The method for heat-treating a wafer according to claim 1, wherein
control is performed in such a way that the temperature of the first principal surface becomes 1 to 25°C higher than the temperature of the second principal surface by changing the ratio of an output of a first heating source heating the first principal surface of the wafer to an output of a second heating source heating the second principal surface.

3. The method for heat-treating a wafer according to claim 2, wherein
a halogen lamp is used as the first heating source and the second heating source, and the output of the second heating source is set to 10 to 90% of the output of the first heating source.

4. The method for heat-treating a wafer according to claim 1 or 2, wherein
a halogen lamp is used as the heating source.

5. The method for heat-treating a wafer according to any one of claims 1 to 4, wherein
the supporting member is made to support the outer periphery of the wafer horizontally at a plurality of supporting points.

6. The method for heat-treating a wafer according to any one of claims 1 to 5, wherein
the predetermined temperature is set at 700°C or higher but lower than 1150°C.

7. The method for heat-treating a wafer according to any one of claims 1 to 5, wherein
the predetermined temperature is set at 1150°C or higher but lower than 1250°C.

8. The method for heat-treating a wafer according to any one of claims 1 to 5, wherein
the predetermined temperature is set at 1250°C or higher.

9. A method for producing a silicon wafer, comprising at least:
growing a silicon single crystal ingot by the Czochralski method;
slicing and processing the silicon single crystal ingot into a silicon single crystal substrate; and
performing heat treatment on the silicon single crystal substrate by the method for heat-treating a wafer according to any one of claims 1 to 8.

10. A silicon wafer on which heat treatment has been performed by the method for heat-treating a wafer according to any one of claims 1 to 8.

11. A heat treatment apparatus for performing, on a wafer, heat treatment at a predetermined temperature with rapid rise and fall of temperature, comprising at least:
a chamber for housing the wafer;
a supporting member supporting a first principal surface of the wafer;
a first heating source heating the first principal surface of the wafer;
a second heating source heating a principal surface (a second principal surface) opposite to the first principal surface of the wafer; and
a control mechanism for controlling outputs of the first heating source and the second heating source separately, wherein
the control mechanism controls the outputs of the first heating source and the second heating source separately in such a way that the temperature of the first principal surface supported by the supporting member becomes 1 to 25°C higher than the temperature of the principal surface (the second principal surface) opposite to the first principal surface of the wafer.

12. The heat treatment apparatus according to claim 11, wherein
the first and second heating sources are halogen lamps.
